# EUROPÄISCHE PATENTSCHRIFT

(11) **EP 0 496 203 B1**
(45) Veröffentlichungstag und Bekanntmachung des Hinweises auf die Patenterteilung: **03.05.1995**
(21) Anmeldenummer: 92100165.7
(22) Anmeldetag: 08.01.1992
(51) Int. Cl.: C09D 4/02, C08F 265/06, C08F 230/02, C08F 299/00

(54) **Lagerstabile Lösung eines carboxylgruppenhaltigen Copolymerisats sowie Verfahren zur Herstellung von photoempfindlichen Lacken und Offsetdruckplatten**
Storage stable solution of a carboxylic groups containing copolymer and procedure for manufacture of photosensitive coatings and offset printing plates
Solutions stables au stockage d'un copolymère contenant des groupes carboxyliques et procédé pour la fabrication des revêtements photosensibles et des plaques d'impression offset

(30) Priorität: 25.01.1991 DE 4102173
(43) Veröffentlichungstag der Anmeldung: 29.07.1992
(73) Patentinhaber: BASF Aktiengesellschaft, 67063 Ludwigshafen (DE)
(72) Erfinder: Lauke, Harald, Dr., W-6800 Mannheim 1 (DE); Loerzer, Thomas, Dr., W-6730 Neustadt (DE); Sanner, Axel, Dr., W-6710 Frankenthal (DE); Roser, Joachim, Dr., W-6800 Mannheim 1 (DE)

(56) Entgegenhaltungen:
- EP-A- 0 175 035
- EP-A- 0 422 647
- GB-A- 1 500 730

## Beschreibung

Die Erfindung betrifft lagerstabile Lösungen carboxylgruppenhaltiger Copolymerisate, deren Carboxylgruppen teilweise mit Glycidyl(meth)acrylat umgesetzt sind, sowie Verfahren zur Herstellung photoempfindlicher Lacke und Offsetdruckplatten unter Verwendung dieser lagerstabilen Lösungen.

Photopolymerisierbare Gemische finden eine breite Anwendung, beispielsweise bei der Herstellung von lichthärtbaren Überzügen, Lacken, Druckfarben, Schutz- und Resistschichten, photopolymeren Druckformen, Kopierfilmen und dergleichen. Eine wesentliche Anforderung an diese photopolymerisierbaren Gemische ist, daß sie eine möglichst hohe Photoempfindlichkeit besitzen, d.h. daß die bei der Bestrahlung mit aktinischem Licht induzierte Photopolymerisation bzw. Photohärtung, unabhängig von sonstigen Einflüssen, möglichst rasch abläuft. Dieses Erfordernis gilt insbesondere beim Einsatz der photopolymerisierbaren Gemische für die optische Informationsfixierung und in der Reproduktionstechnik, da hier die Dauer der Photopolymerisation maßgeblich die gesamte Verarbeitungszeit beeinflußt.

Es ist bekannt, daß Sauerstoff aufgrund seiner inhibierenden Wirkung auf die radikalische Polymerisation die Empfindlichkeit photopolymerer Gemische herabsetzt.

Dies gilt in besonderem Maße für den Offsetdruck, da dort Schichtdicken von 1 - 5 »m üblich sind. In der DE-A-3 037 521 wird eine photopolymerisierbare Masse beschrieben, die eine ethylenisch ungesättigte, photopolymerisierbare Verbindung, ein polymeres Bindemittel, einen Photopolymerisationsinitiator sowie eine Aminogruppen enthaltende s-Triazin-Verbindung enthält. Als Photopolymerisationsinitiator werden unter anderem Anthrachinon und dessen Derivate, Benzophenon und Benzophenon-Derivate, wie Michlers Keton, sowie Kombinationen dieser Verbindungen genannt. Die aminogruppenhaltige s-Triazin-Verbindung dient hier der Haftungsverbesserung der photopolymerisierbaren Masse auf einem Substrat.

Zur Unterdrückung der Sauerstoff-Inhibierung bei der Photopolymerisation ist auch schon vorgeschlagen worden, den photopolymerisierbaren Gemischen Sauerstoffänger zuzumischen. Hierdurch kann häufig ein positiver Einfluß auf die Photopolymerisation erzielt werden. Beispielsweise ist 1,3-Diphenylisobenzofuran ein effizienter Sauerstoffänger für bestimmte photopolymerisierbare Gemische (vgl. z.B. Photographic Sci.Eng. 23 (1979), S. 137 bis 140).

Oft kann die angestrebte Photoempfindlichkeit nur durch Aufbringen einer sauerstoffundurchlässigen Deckschicht auf das photoempfindliche Gemisch erreicht werden. Solche Deckschichten wirken jedoch im Fall von lichtempfindlichen Aufzeichnungselementen mit dünnen photopolymerisierbaren Schichten, wie sie unter anderem bei der Herstellung von Resistschichten und Flachdruckformen eingesetzt werden, wo die sauerstoffsperrende Deckschicht in aller Regel dicker ist als die photopolymerisierbare Schicht der lichtempfindlichen Aufzeichnungselemente, auflösungsvermindernd.

In der EP-A 234 570 wird ein System beschrieben, welches sich auch ohne Sauerstoffbarriere durch eine hohe Photoempfindlichkeit auszeichnet. Als besonders vorteilhaft hat sich dabei die Kombination von Michler's Keton mit einem Säurespender, wie Bis(-trichlormethyl)styrol-s-triazin als Photoinitiatorsystem in Verbindung mit einem oder mehreren ethylenisch ungesättigten, photopolymerisierbaren Verbindungen bewährt, insbesondere die Kombination von carboxylgruppenhaltigen (Meth)acrylatcopolymeren, bei denen die Carboxylgruppen partiell mit Glycidylmethacrylat verestert wurden, (= funktionalisiertes Polymer), mit einem oder mehreren, mehrfach ethylenisch ungesättigten Acrylatmonomeren.

Ein Nachteil dieser photoempfindlichen vernetzbaren Gemische auf der Basis funktionalisierter (radikalisch vernetzender) Bindemittel ist, daß diese reaktiven Bindemittel sowie die daraus hergestellten Gemische bei längerer Lagerung in Lösung zu einem starken Anstieg der Viskosität neigen. Der Viskositätsanstieg konnte auch durch Zugabe thermischer Polymerisationsinhibitoren nicht merklich verzögert werden.

Aufgrund dieser nur bedingten Lagerfähigkeit war es daher notwendig, das funktionalisierte Polymere nach dessen Herstellung sofort in einem großen Überschuß an Wasser auszufällen, abzufiltrieren, zu trocknen und als Pulver bis kurz vor dessen Verwendung als Bindemittel für photoempfindliche Gemische für Offsetdruckplatten zu lagern. Dieser Prozeß ist sehr zeit- und kostenintensiv, zudem muß das in großer Menge anfallende Abwasser entsorgt werden.

Aufgabe der vorliegenden Erfindung war es daher, einen Weg zu finden, derartige reaktive Polyacrylate durch geeignete Zusatzstoffe so zu stabilisieren, daß deren Lösung über einen Zeitraum von mehreren Monaten unter normalen Bedingungen ohne Anstieg der Viskosität gelagert werden kann. Dabei durften die zu diesem Ziel Führenden Maßnahmen sich nicht negativ auf die an einen photopolymerisierbaren Lack bzw. eine photopolymerisierbare Offsetdruckplatte gestellten Anforderungen, wie hohe Lichtempfindlichkeit ohne Sauerstoffsperrschicht, leichte Entwickelbarkeit der unbelichteten Bereiche sowie hohe mechanische Abriebfestigkeit der photogehärteten Schicht, auswirken.

Überraschenderweise läßt sich diese Aufgabe durch Zugabe eines Phosphorsäureesters eines Hydroxyalkyl(meth)acrylats lösen.

Phosphorsäureacrylate und deren Herstellung durch Umsetzung von 2-Hydroxyethyl(meth)acrylat mit P₂O₅ sind bereits aus der US-A-3 686 371 bekannt.

In der US-A-3 867 351 werden Phosphorsäure(meth)acrylate für elektrisch leitende Zusammensetzungen, in der US-A-3 754 972 als Haftvermittler beschrieben. Lackzusammensetzungen, die Phophorsäureacrylate enthalten und mit ionisierender Strahlung zu polymerisieren sind, können der US-A-3 984 500 entnommen werden. In der DE-C-26 16 946 werden anaerob härtende Klebstoffe mit einem Zusatz von mindestens 0,05 Gew.-% Phosphorsäureacrylat beschrieben.

Gegenstand der vorliegenden Erfindung ist eine lagerstabile Lösung eines filmbildenden carboxylgruppenhaltigen Copolymerisats, dessen Carboxylgruppen zu 5 bis 80 % mit Glycidyl(meth)acrylat umgesetzt sind, in einem inerten organischen Lösungsmittel oder Lösungsmittelgemisch, die dadurch gekennzeichnet ist, daß die Lösung zusätzlich 1 bis 50 Gew.-%, bezogen auf carboxylgruppenhaltiges polymeres Umsetzungsprodukt, eines Phophorsäureesters eines Hydroxyalkyl(meth)acrylats, sowie gegebenenfalls o-Phosphorsäure enthält.

Gegenstand der vorliegenden Erfindung ist auch ein Verfahren zur Herstellung photoempfindlicher Lacke, die mindestens einen Photoinitiator, mindestens eine radikalisch polymerisierbare ethylenisch ungesättigte organische monomere Verbindung, sowie gegebenenfalls Weichmacher, Farbstoffe, Farbbildner und Inhibitoren gegen die thermische Polymerisation enthalten, das dadurch gekennzeichnet ist, daß die Herstellung dieser Lacke in einer erfindungsgemäßen lagerstabilen Lösung erfolgt.

Außerdem ist ein Verfahren zur Herstellung von Offsetplatten Gegenstand der Erfindung, bei dem zur Herstellung der photoempfindlichen Schicht ein erfindungsgemäß hergestellter photoempfindlicher Lack eingesetzt wird.

Durch den erfindungsgemäßen Zusatz von Phosphorsäureestern eines Hydroxyalkyl(meth)acrylats gelingt es, die Viskosität der Lösungen filmbildender carboxylgruppenhaltiger Copolymerisate, deren Carboxylgruppen teilweise mit Glycidyl(meth)acrylat umgesetzt sind, über einen längeren Zeitraum von ca. 6 bis 12 Monaten konstant zu halten. Die so stabilisierte Lösung kann sehr vorteilhaft als Grundlage für die Herstellung eines photopolymerisierbaren Lackes zur Herstellung von Offsetdruckplatten verwendet werden. Überraschenderweise weist die damit hergestellte lichtempfindliche Schicht auch eine verbesserte Lagerstabilität (= Erhalt der Hydrophilie des Trägers beim Entwickeln) der photopolymeren Offsetdruckplatte auf.

Zu den Aufbaukomponenten der erfindungsgemäßen Lösungen und deren Weiterverarbeitung ist im einzelnen folgendes auszuführen.

Als Phosphorsäureester eines Hydroxyalkyl(meth)acrylats kommen solche der allgemeinen Formel 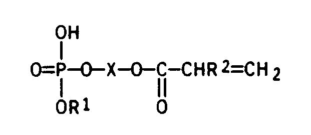
mit
R¹ = H oder 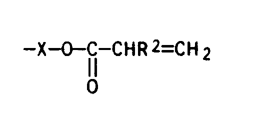
R² = H oder CH₃
X = (CH₂)ₙ mit n = 1 bis 4, vorzugsweise 2 in Betracht.

Bevorzugt sind die Veresterungsprodukte von Phosphorsäure mit Hydroxyethylacrylat oder Hydroxyethylmethacrylat im molaren Verhältnis 1:1.

Auch Veresterungsprodukte der Phosphorsäure mit Hydroxyethyl(meth)acrylat im molaren Verhältnis 1:2 und deren Gemische mit o-Phosphorsäure sind geeignet.

Die Phosphorsäureester der Hydroxyalkyl(meth)acrylate sind im erfindungsgemäßen Gemisch in einer Menge von 1 bis 50, vorzugsweise 5 bis 20 Gew.-%, bezogen auf filmbildendes mit Glycidyl(meth)acrylat modifiziertes carboxylgruppenhaltiges Copolymerisat enthalten.

Als filmbildende carboxylgruppenhaltige Copolymerisate, die als Ausgangsprodukte für die Modifizierung mit Glycidyl(meth)acrylat dienen, kommen Copolymerisate der Acrylsäure oder Methacrylsäure in Betracht, vorzugsweise Copolymerisate der Acrylsäure und/oder Methacrylsäure mit Methylmethacrylat, wobei Methylmethacrylat auch teilweise durch andere carboxylgruppenfreie copolymerisierbare ethylenisch ungesättigte organische Verbindungen, wie z.B. durch Vinylaromaten, wie Styrol, oder Ester der Acrylsäure mit 1 bis 8, insbesondere 1 bis 4 Kohlenstoffatome enthaltenden Alkanolen, wie z.B. Acrylsäuremethylester, Acrylsäureethylester, Acrylsäureisopropylester, Acrylsäure-n-butylester und/oder Acrylsäureisobutylester, ersetzt sein kann.

Besonders bevorzugt sind Copolymerisate aus 50 bis 80, insbesondere 65 bis 75 Gew.-% Methylmethacrylat und 20 bis 50, insbesondere 25 bis 35 Gew.-% Acrylsäure und/oder Methacrylsäure, die K-Werte (nach Fikentscher) zwischen 20 und 50 aufweisen. Sie können durch übliche radikalisch initiierte Copolymerisation der Monomeren nach üblichen Verfahren, beispielsweise durch Lösungspolymerisation in inerten organischen Lösungsmitteln, wie Ketone und Ether, z.B. Aceton, Tetrahydrofuran, Glykolether, insbesondere Diethylenglykoldimethylether, in Gegenwart radikalliefernder Initiatoren, wie z.B. Azobisisobutyronitril und organischen Peroxiden hergestellt werden.

Diese carboxylgruppenhaltigen Copolymerisate werden mit solchen Mengen Glycidylacrylat und/oder Glycidylmethacrylat umgesetzt, daß 5 bis 80, vorzugsweise 30 bis 60 % der im carboxylgruppenhaltigen Copolymerisat ursprünglich vorhandenen Carboxylgruppen mit Glycidyl(meth)acrylat umgesetzt sind. Diese Umsetzung wird üblicherweise in einem inerten organischen Lösungsmittel oder Lösungsmittelgemisch, beispielsweise in einem Ether wie z.B. Diethylenglykoldimethylether, bei Temperaturen zwischen 50 und 140°C, beispielsweise bei 110°C, zweckmäßigerweise in Gegenwart eines Inhibitors (z.B. Xyligen® Al der BASF Aktiengesellschaft oder Hydrochinonmonomethylether) und eines Veresterungskatalysators, wie z.B. Tetrabutylammoniumjodid, Dimethylaminopyridin oder N-Methylimidazol durchgeführt.

Als inerte organische Lösungsmittel, bzw. Lösungsmittelgemische kommen die bereits oben genannten in Frage. Als Lösungsmittel bevorzugt sind solche, in welchen sowohl polymerisiert als auch Funktionalisiert (= Umsetzung mit Glycidyl(meth)acrylat) werden kann. Bevorzugt als inerte Lösungsmittel sind auch Gemische aus Tetrahydrofuran und Diethylenglykoldimethylether oder aus Aceton und Diethylenglykoldimethylether.

Die erfindungsgemäßen lagerstabilen Lösungen weisen über einen langen Zeitraum Konstante Viskosität auf und eignen sich zur Herstellung photopolymerisierbarer Lacke, insbesondere zur Herstellung von photopolymeren Offsetdruckplatten.

Als Photoinitiatoren, die bei Bestrahlung mit aktinischem Licht die Polymerisation der ethylenisch ungesättigten Verbindungen in den photopolymerisierbaren Gemischen zu initiieren vermögen, eignen sich eine Vielzahl von Verbindungen. Hierzu gehören beispielsweise Benzoinether, Benzilketale, Benzoylacylphosphinoxid-Verbindungen, mehrkernige Chinone, wie Anthrachinon und seine Derivate, Benzophenon und seine Derivate, Thioxanthone, mindestens eine Halogenmethyl-Gruppe enthaltende s-Triazin-Derivate, Hexaarylbisimidazole und andere. Eine Zusammenstellung einer Vielzahl von photopolymerisierbaren Systemen mit den verschiedensten Photoinitiatoren findet sich beispielsweise in dem Artikel "Photopolymersysteme und ihre Anwendungen" von H.-J. Timpe und H. Baumann, Chemische Technik 36 (1984), S. 1 bis 7. Zur Verbesserung der Photoempfindlichkeit der photopolymerisierbaren Gemische können auch Kombinationen von Photoinitiatoren bzw. von einem Photoinitiator und einem Sensibilisierungsmittel verwendet werden. Ein bekanntes und sehr breit angewandtes Photoinitiator-System dieser Art ist die Kombination von Benzophenon und Michlers Keton (vgl. u.a. DE-A-1 522 359). Im allgemeinen werden Amino-Gruppen enthaltende Verbindungen als Sensibilisatoren für Photoinitiatoren eingesetzt (vgl. z.B. EP-A-138 187 und GB-A-2 083 832). Ferner sind, beispielsweise in der DE-A-2 934 758, der US-A-4 239 850 und der JP-A-55050001, Mischungen von mindestens eine Halogenmethyl-Gruppe enthaltenden s-Triazinen mit bestimmten Dialkylamino-Gruppen enthaltenden aromatischen Carbonylverbindungen bzw. N-heteroaromatischen Carbonylverbindungen als Photoinitiator-Kombination beschrieben.

Als ethylenisch ungesättigte, photopolymerisierbare Monomere für das erfindungsgemäße photopolymerisierbare Gemisch zur Herstellung photoempfindlicher Lacke kommen grundsätzlich alle ethylenisch ungesättigten Monomere in Betracht, die einer photoinitiierten Polymerisations- oder Vernetzungsreaktion zugänglich sind. Hierzu gehören sowohl Monomere, als auch ethylenisch ungesättigte, photopolymerisierbare Oligomere und entsprechende ungesättigte Polymere. Die Monomeren haben dabei im allgemeinen ein Molekulargewicht unter 1.000. Bevorzugt sind solche ethylenisch ungesättigten, photopolymerisierbaren Verbindungen, deren photopolymerisierbaren Doppelbindungen durch z.B. Aryl-, Carbonyl-, Amid-, Ester-, Carboxy- oder Nitril-Gruppen, Halogenatome, C-C-Doppel- oder C-C-Dreifachbindungen aktiviert sind. Die ethylenisch ungesättigten, photopolymerisierbaren Verbindungen können sowohl mono- als auch polyfunktionell sein, d.h. sie können eine oder mehrere photopolymerisierbare, ethylenische Doppelbindungen enthalten. Üblicherweise sind in den photopolymerisierbaren Gemischen, insbesondere wenn sie für die Herstellung von lichtempfindlichen Aufzeichnungselementen eingesetzt werden, bi- oder mehrfunktionelle ethylenisch ungesättigte, photopolymerisierbare Verbindungen allein oder Mischungen hiervon mit einem untergeordneten Anteil an monofunktionellen ethylenisch ungesättigten, photopolymerisierbaren Verbindungen enthalten. Die ethylenisch ungesättigten, photopolymerisierbaren Verbindungen, die allein oder in Mischung miteinander vorliegen, sind in der einschlägigen Fachliteratur hinreichend beschrieben. Ihre Auswahl, nach Art und Menge, richtet sich insbesondere nach dem Anwendungszweck der photopolymerisierbaren Gemische und ist dem Fachmann geläufig.

Zu den ethylenisch ungesättigten, photopolymerisierbaren Monomeren gehören beispielsweise die Vinylverbindungen, wie Vinylether, Vinylester, Styrol, Vinylchlorid, Vinylidenchlorid, Vinylketone, Vinylsulfone, N-Vinylpyrrolidon, N-Vinylcaprolactam, N-Vinylcarbazol, aber auch Allylester, wie Diallylphthalat. Besonders vorteilhaft sind die Acryloyl-und/oder Methacryloyl-Gruppen enthaltenden Monomeren. Hierzu gehören insbesondere die Ester der Acrylsäure und Methacrylsäure, wie z.B. die Di-und Tri-(meth)acrylate von zwei- oder mehrwertigen Alkoholen, wie etwa von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit sowie Pentaerythrittetra-(meth)acrylat; die Monoacrylate und Monomethacrylate der genannten Diole oder Polyole, wie z.B. Ethylenglykol-, Di-, Tri- oder Tetraethylenglykolmono(meth)acrylat, Propandiol-mono(meth)acrylat und Butandiol-mono(meth)acrylat; die (Meth)acrylate von Monoalkanolen, insbesondere von solchen mit 1 bis 20 C-Atomen; (Meth)Acrylamid, N-Methylol-(meth)acrylamid, Methylen-bis-(meth)acrylamid, der Bisether des Ethylenglykols und N-Methylol-(meth)acrylamids; Urethanacrylate und -methacrylate mit 2 oder mehr Acryloyl- bzw. Methacryloyl-Gruppen, wie sie beispielsweise durch Umsetzung von organischen Di- oder Polyisocyanaten mit Monohydroxi-(meth)acrylaten, insbesondere Hydroxialkyl-(meth)acrylaten, hergestellt werden können; (Meth)acrylat-Monomere mit 2 oder mehr Acryloyl- und/oder Methacryloyl-Gruppen, wie sie durch Umsetzung von Acrylsäure und/oder Methacrylsäure mit Di- oder Polyglycidylverbindungen, insbesondere Di- oder Polyglycidylethern, erhalten werden können, wie z.B. das Umsetzungsprodukt aus 2 Mol Acrylsäure und/oder Methacrylsäure mit 1 Mol Bisphenol A-bis-glycidylether.

Zu den insbesondere bevorzugten photopolymerisierbaren ethylenisch ungesättigten Monomeren gehören unter anderem Trimethylolpropantriacrylat, Trimethylolpropantrimethacrylat, Pentaerythrittri- und -tetraacrylat, Pentaerythrittri- und -tetramethacrylat sowie monomere Epoxid(meth)acrylate der vorstehend genannten Art, z.B. ethoxyliertes Bisphenol-A-Diacrylat.

Neben den Photoinitiatoren und den ethylenisch ungesättigten, photopolymerisierbaren Verbindungen können die erfindungsgemäßen photopolymerisierbaren Gemische zur Herstellung von Lacken weitere Zusatz- und/oder Hilfsstoffe, insbesondere zur Verbesserung bzw. Modifizierung der anwendungs- und/oder verarbeitungstechnischen Eigenschaften, enthalten. Zu derartigen Zusatz- und/oder Hilfsstoffen gehören u.a. thermische Polymerisationsinhibitoren, Farbstoffe und/oder Pigmente, Füllstoffe, filmbildende nicht-photopolymerisierbare und nicht-photovernetzbare Polymere, Weichmacher, Verlaufshilfsmittel, Mattierungs- oder Gleitmittel, Verstärkungsmittel, UV-Stabilisatoren, photochrome Systeme, Sensibilisatoren und dgl. Diese Zusätze sind in den photopolymerisierbaren Gemischen - sofern sie vorhanden sind - in wirksamen Mengen enthalten, wie sie für diese Stoffe üblich und gebräuchlich und dem Fachmann geläufig sind. Sind in den photopolymerisierbaren Gemischen neben den ethylenisch ungesättigten, photopolymerisierbaren Verbindungen filmbildende, nicht-photopolymerisierbare und nicht-photovernetzbare polymere Bindemittel enthalten, wie z.B. Polyamide, Vinylalkohol-Polymere, teilverseifte Polyvinylacetate, Polyurethane, (Meth)acrylat(co)polymerisate, Styrol(co)polymerisate und dgl., so werden - wenn die photopolymerisierbaren Gemische für die Herstellung von lichtempfindlichen Lacken oder Aufzeichnungselementen eingesetzt werden sollen - diese filmbildenden polymeren Bindemittel so gewählt, daß sie mit den ethylenisch ungesättigten, photopolymerisierbaren Verbindungen verträglich sind.

Geeignete thermische Polymerisationsinhibitoren, die in den photopolymerisierbaren Gemischen zur Herstellung von Lacken enthalten sein können, sind z.B. Hydrochinon, Hydrochinon-Derivate, 2,6-Di-t.-butyl-p-kresol, Nitrophenole, N-Nitrosodiphenylamin oder die Salze des N-Nitrosocyclohexylhydroxylamins. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau BO (C.I. 42 595), Viktoria-Blau B (C.I. 44 045), Rhoadmin 6G (C.I. 45 160) u.a. photochrome Systeme, die bei Belichtung mit aktinischem Licht reversibel oder irreversibel ihre Farbe ändern, ohne hierbei den Photopolymerisationsprozeß zu stören, sind z.B. Leukofarbstoffe zusammen mit geeigneten Aktivatoren oder Photooxidantien. Die photopolymerisierbaren Gemische können bei ihrem Einsatz in lichtempfindlichen Aufzeichnungselementen auch sensitometrische Regler enthalten, wie z.B. 9-Nitroanthracen, 10,10'-Bisanthron, Phenacinium-, Phenoxacinium-, Acridinium- oder Phenothiacinium-Farbstoffe, insbesondere in Kombination mit milden Reduktionsmitteln, 1,3-Dinitrobenzole und ähnliche.

Die unter Verwendung der erfindungsgemäßen lagerstabilen Lösungen hergestellten photopolymerisierbaren Gemische sind sehr vielseitig anwendbar und eignen sich insbesondere für die Herstellung von dünnen lichthärtbaren Schichten, beispielsweise einer Schichtdicke im Bereich von etwa 0,1 bis 50 »m, insbesondere für Offsetdruckplatten. Sie können in an sich bekannter Weise zur Herstellung von lichthärtbaren Lacken, zu Schutz- oder Dekorationszwecken dienenden Überzügen auf beliebigen Substraten, wie z.B. Metallen, Holz, Kunststoffen, Glas, Papier oder Pappe, von Tränkmaterialien oder von lichthärtbaren Druckfarben dienen. Zur Härtung und Photopolymerisation kommen dabei die üblichen Lichtquellen für aktinisches Licht in Betracht, insbesondere solche, deren Emissionsmaxima zwischen 300 und 420 nm liegen.

In besonders vorteilhafter Weise eignen sich die erfindungsgemäßen photopolymerisierbaren Gemische für die Herstellung von lichtempfindlichen Aufzeichnungselementen mit dünnen, lichtempfindlichen, photopolymerisierbaren Aufzeichnungsschichten, wie sie in der Reproduktionstechnik neben der Anwendung als Photoresist insbesondere bei der Herstellung von Flachdruckformen üblich und gebräuchlich sind.

Diese lichtempfindlichen Aufzeichnungselemente enthalten dabei eine auf einem dimensionsstabilen Träger aufgebrachte lichtempfindliche, photopolymerisierbare Aufzeichnungsschicht aus einem erfindungsgemäß hergestellten photopolymerisierbaren Gemisch. Die lichtempfindliche, photopolymerisierbare Aufzeichnungsschicht dieser lichtempfindlichen Aufzeichnungselemente besitzt dabei üblicherweise eine Schichtdicke im Bereich von etwa 0,1 bis 50 »m. Während für Photoresistfilme dickere Aufzeichnungsschichten in Betracht kommen, beispielsweise im Bereich von 5 bis 50 »m, liegt die Dicke der photopolymerisierbaren Aufzeichnungsschicht für Flachdruckplatten vorzugsweise im Bereich von 0,5 bis 8 »m, insbesondere im Bereich von 0,7 bis 3,5 »m.

Als Trägermaterialien für derartige photopolymerisierbare Aufzeichnungsschichten kommen die für lichtempfindliche Aufzeichnungselemente an sich üblichen und bekannten dimensionsstabilen, starren oder flexiblen Schichtträger in Betracht, wobei die Art des Schichtträgers vom Verwendungszweck der lichtempfindlichen Aufzeichnungselemente abhängt. Geeignete dimensionsstabile Schichtträger sind insbesondere Kunststoff-Filme oder -Folien, z.B. aus Polyethylenterephthalat, sowie metallische Schichtträger, wie z.B. Aluminium, Stahl, Kupfer, Messing oder Zinkfolien, die wie für Offsetdruckplatten üblich vorbehandelt werden können. (Vgl. beispielsweise Wernick, Pinner, Zurbrügg, Weiner "Die Oberflächenbehandlung von Aluminium, Eugen G. Lenze Verlag, 1977).

Die in den Beispielen genannten Teile und Prozente sind, soweit nicht anders angegeben, Gewichtsteile bzw. Gewichtsprozente.

### Herstellung des modifizierten carboxylgruppenhaltigen Copolymerisats:

70 Teile Methylmethacrylat und 30 Teile Methacrylsäure (= MAS) wurden in Diethylenglykoldimethylether mittels Azobisisobutyronitril copolymerisiert (30 %ige Lösung). Der Reaktionsansatz wurde solange auf 80°C gehalten, bis sämtliches Startermaterial abreagiert war. Dann wurde der Ansatz mit Diethylenglykoldimethylether auf einen Feststoffgehalt von 10 % verdünnt und mit 0,1 %, bezogen auf Feststoffgehalt, Hydrochinonmonomethylether versetzt. Anschließend wurden die Carboxylgruppen des Copolymeren partiell mit Glycidylmethacrylat verestert. Bezogen auf den Methacrylsäureanteil des Copolymeren wurden pro mol MAS 0,66 mol Glycidylmethacrylat zugegeben. Als Veresterungskatalysator wurde Tetrabutylammoniumiodid verwendet.

Die Veresterung erfolgte bis zu einer Säurezahl von 75 mg KOH/g Polymer.

Diese Lösung des modifizierten Copolymerisats diente für die Untersuchung der Wirksamkeit verschiedener Zusätze im Hinblick auf deren Fähigkeit zu stabilisieren.

### Vergleichsbeispiele 1 bis 3 und erfindungsgemäßes Beispiel 4:

| modifizierte Copolymerisatlösung | Zusatz (% bezogen auf Feststoff) |
|---|---|
| 1 (Vergleich) | - |
| 2 (Vergleich) | mit 1 % Hydrochinonmonomethylether |
| 3 (Vergleich) | mit 1 % Xyligen Al |
| 4 (erfindungsgemäß) | mit 10 % Methacryloxyethylphosphat (z.B. Kayamer® PM-1 der Fa. Nippon Kayaku) |

### Untersuchung der Lagerstabilität:

| modifizierte Copolymerisatlösung | Viskosität [mm²/s] nach Wochen bei Lagerung bei 25°C (Ubbelohde Viskosimeter) | | | | |
|---|---|---|---|---|---|
| | 0 | 5 | 18 | 30 | 52 |
| 1 (Vergleich) | 14,9 | 18,9 | 21,0 | 24,5 | 30,5 |
| 2 (Vergleich) | 14,9 | 18,7 | 20,9 | 24,5 | 30,4 |
| 3 (Vergleich) | 14,9 | 19,0 | 21,0 | 24,4 | 29,8 |
| 4 (erfindungsgemäß) | 12,4 | 12,4 | 12,5 | 12,6 | 12,6 |

### Herstellung einer photopolymerisierbaren Offsetdruckplatte auf der Basis der unterschiedlich gelagerten Polymerlösungen:

Ein elektrochemisch durch Wechselstrombehandlung in wäßriger HCl-Lösung aufgerauhtes und anodisch oxidiertes Aluminiumblech mit einem Oxidgewicht von 3 g/cm² wurde für 30 Sekunden in eine Lösung enthaltend 0,1 Gew.-% K₂ZrF₆ und 0,5 Gew.-% [2-Trihydroxysilyl)]ethylphosphonsäure getaucht und anschließend mit vollentsalztem Wasser gründlich abgespült.

Die auf diese Weise hergestellten Träger wurden mit verschiedenen photoempfindlichen Lacken so beschichtet, daß das Schichtgewicht 2,5 g/cm² betrug.

Die photoempfindlichen Lacke besitzen folgende Zusammensetzung:
a)* 59 % Modifiziertes Copolymerisat gemäß den Vergleichsbeispielen 1-3)
   30 % Monomer (aromatisches difunktionelles Acrylat = ethoxyliertes Bisphenol-A, mit 2 Moläquivalenten Acrylsäure umgesetzt, z.B. Photomer® 4028, Fa. Henkel USA)
   2 % Michler's Keton
   6 % 2-(4'-Methoxynaphthyl-1')-4,6-bis-(trichlormethyl)-s-triazin
   1 % Bromphenolblau
   2 % Weichmacher (Benzolsulfonsäure-n-butylamid)
b)* 59 % Modifiziertes Copolymerisat, erfindungsgemäß enthaltend zusätzlich
   6 % Methacryloxyethylphosphat
   24 % Monomer (wie bei a)
   restliche Komponenten wie bei a)
Diese unterschiedliche Zusätze enthaltenden modifizierten Copolymerisatlösungen wurden nach 0-, 5-, 18-, 30- und 52-wöchiger Lagerung zur HerStellung von Offsetdruckplatten verwendet. Diese Druckplatten wurden einem beschleunigten Lagertest im Klimaschrank (60°C, 50 % Luftfeuchtigkeit) unterzogen und in regelmäßigen Abständen mit einem wäßrig alkalischen Entwickler (Nylolith® EN10 der BASF) entwickelt. Die entwickelten Druckplatten wurden dann mit Offsetdruckfarbe eingefärbt. Es wurde die Lagerzeit ermittelt, nach der die Trägeroberfläche zur Farbannahme als Folge einer ungenügenden Entwickelbarkeit der lichtempfindlichen Schicht neigte.
*) % = Gewichtsprozent bezogen auf Feststoffgehalt
die Lösungen haben einen Feststoffgehalt von 14,5 % in Diethylenglykoldimethylether

Versuche zur Ermittlung der Auswirkungen von gelagerten Bindemittellösungen auf die Eigenschaften damit hergestellter Offsetdruckplatten.

Farbannahmestörungen der entwickelten Offsetdruckplatten nach Tagen bei Verwendung der bei Raumtemperatur gelagerten Bindemittellösungen (0, 5, 18, 30, 52 Wochen).

### Lagerbedingung der Offsetdruckplatten: 60°C, 55 % Feuchte

| Bindemittellösungen | Lagerzeit der Bindemittellösungen in Wochen | | | | |
|---|---|---|---|---|---|
| | 0 | 5 | 18 | 30 | 52 |
| | Farbannahmestörungen der entwickelten Offsetdruckplatte nach Tagen im Klimaschrank | | | | |
| Vergleichsbeispiel 1 | 6 | 5 | 2 | 0* | 0* |
| Vergleichsbeispiel 2 | 6 | 5 | 2 | 0* | 0* |
| Vergleichsbeispiel 3 | 6 | 4 | 2 | 0* | 0* |
| erfindungsgemäßes Beispiel 4 | 15 | 15 | 14 | 14 | 13 |

| | | | | | |
|---|---|---|---|---|---|
| *) Farbannahmestörungen bereits bei frisch hergestellter, nicht im Klimaschrank gelagerter Druckplatte (keine einwandfreie Entwicklung möglich) | | | | | |

Muster der Druckplatten gemäß Vergleichsbeispiel 1 bis 3 und gemäß erfindungsgemäßem Beispiel 4 wurden nach bildmäßiger Belichtung mittels Quecksilberhochdrucklampe und Entwicklung auf einer Druckmaschine (Heidelberger GTO Bogenoffsetdruckmaschine) einem Auflagendruck unterzogen. Mit allen Druckplatten konnte eine Auflagenhöhe von 200.000 Bogen ohne ersichtliche Abnutzungserscheinungen der druckenden Schicht erreicht werden.

## Patentansprüche

1. Lagerstabile Lösung eines filmbildenden carboxylgruppenhaltigen Copolymerisats, dessen Carboxylgruppen zu 5 bis 80 % mit Glycidyl(meth)acrylat umgesetzt sind, in einem inerten organischen Lösungsmittel oder Lösungsmittelgemisch, dadurch gekennzeichnet, daß die Lösung zusätzlich 1 bis 50 Gew.-%, bezogen auf carboxylgruppenhaltiges polymeres Umsetzungsprodukt, eines Phophorsäureesters eines Hydroxyalkyl(meth)acrylats, sowie gegebenenfalls o-Phosphorsäure enthält.

2. Verfahren zur Herstellung photoempfindlicher Lacke, die mindestens einen Photoinitiator, mindestens eine radikalisch polymerisierbare ethylenisch ungesättigte organische monomere Verbindung, sowie gegebenenfalls Weichmacher, Farbstoffe, Farbbildner und Inhibitoren gegen die thermische Polymerisation enthalten, dadurch gekennzeichnet, daß die Herstellung dieser Lacke in einer lagerstabilen Lösung gemäß Anspruch 1 erfolgt.

3. Verfahren zur Herstellung von Offset-Druckplatten, dadurch gekennzeichnet, daß zur Herstellung der photoempfindlichen Schicht ein photoempfindlicher Lack nach Anspruch 2 eingesetzt wird.

## Claims

1. A storage-stable solution of a film-forming carboxyl-containing copolymer, from 5 to 80% of whose carboxyl groups have been reacted with glycidyl (meth)acrylate, in an inert organic solvent or solvent mixture, wherein the solution additionally contains from 1 to 50% by weight, based on the carboxyl-containing polymeric reaction product, of a phosphoric ester of a hydroxyalkyl (meth)acrylate and, if required, orthophosphoric acid.

2. A process for the production of a photosensitive coating which contains one or more photoinitiators, one or more ethylenically unsaturated organic monomeric compounds which can be subjected to free radical polymerization and, if required, plasticisers, dyes, dye precursors and thermal polymerization inhibitors, wherein the production of this coating is carried out in a storage-stable solution as claimed in claim 1.

3. A process for the production of an offset printing plate, wherein a photosensitive coating as claimed in claim 2 is used for the production of the photosensitive layer.

## Revendications

1. Solution, stable à la conservation, d'un copolymère filmogène contenant des groupes carboxyle, dont les groupes carboxyle ont réagi en proportions de 5 à 80 % avec du (méth)acrylate de glycidyle, dans un solvant ou mélange solvant organique inerte, caractérisé en ce que la solution contient en outre de 1 à 50 % en poids, par rapport au produit de réaction polymère contenant des groupes carboxyle, d'un ester phosphorique d'un (méth)acrylate d'hydroxyalkyle, et le cas échéant de l'acide o-phosphorique.

2. Procédé pour préparer des vernis photosensibles contenant au moins un photo-inducteur, au moins un composé organique monomère à insaturation éthylénique apte à la polymérisation radicalaire, et le cas échéant des plastifiants, des colorants, des chromogènes et des inhibiteurs de la polymérisation à la chaleur, caractérisé en ce que ces vernis sont préparés dans une solution stable à la conservation selon la revendication 1.

3. Procédé pour former des plaques d'impression en offset, caractérisé en ce que, pour la préparation de la couche photosensible, on utilise un vernis photosensible selon la revendication 2.
